# EUROPÄISCHE PATENTSCHRIFT

(11) **EP 0 474 904 B1**
(45) Veröffentlichungstag und Bekanntmachung des Hinweises auf die Patenterteilung: **27.07.1994**
(21) Anmeldenummer: 90117599.2
(22) Anmeldetag: 12.09.1990
(51) Int. Cl.: H02K 23/66, H02K 7/116, E05F 15/16

(54) **Kommutator-Getriebe-Antriebseinheit, insbesondere Fensterheberantrieb für ein Kraftfahrzeug, und Verfahren zu deren Herstellung**
Gear drive assembly for a commutator motor, in particular window raising drive for an automotive vehicle, and method for its manufacture
Ensemble d'entraînement moto-réducteur à collecteur, en particulier lève-vitre pour un véhicule automobile, et sa méthode de fabrication

(43) Veröffentlichungstag der Anmeldung: 18.03.1992
(73) Patentinhaber: SIEMENS AKTIENGESELLSCHAFT, 80333 München (DE)
(72) Erfinder: Fiedler, Rudolf, Dipl.-Ing. (FH), D-6990 Bad Mergentheim (DE); Steinshorn, Axel, Dipl.-Ing. (FH), D-6978 Wittighausen (DE)

(56) Entgegenhaltungen:
- EP-A- 0 252 481
- DE-A- 2 824 384
- DE-A- 3 021 948
- DE-A- 3 805 060
- DE-A- 3 838 285
- DE-U- 9 006 924
- FR-A- 2 580 439
- PATENT ABSTRACTS OF JAPAN vol. 4, no. 112 (E-21)(594) 12 August 1980 ; & JP-A-55 68 847

## Beschreibung

Bei einem bekannten elektromotorischen Fensterheber (DE-U-90 06 924) ist in einem gemeinsamen Gehäuse neben einer Antriebseinheit und einer Getriebeeinheit auch ein Einschubmodul für eine Steuer- und Regelelektronik im wesentlichen parallel zur Antriebseinheit verlaufend angeordnet. Der Einschubmodul besteht aus einem Einschubelement, auf dem die Steuer- und Regelelektronik untergebracht ist und das ein verlängertes, zur Welle der Antriebseinheit gerichtetes Steckelement mit Steckkontakten zur Stromversorgung der Antriebseinheit und Empfängerteile eines Drehzahl-Sensors aufweist.

Bei einer durch die DE-C2-30 21 948 bekannten, insbesondere für Scheibenwischer eines Kraftfahrzeuges, vorgesehenen Antriebseinheit ist ein Steckergehäuse, in dem Stecker festgelegt sind, die mit den Schaltkontakten eines Endlagenschalters und den Bürsten des Kommutatormotors elektrisch leitend verbunden sind, einstückiges Bauteil einer Bürstenhalterplatte, das zwischen dem Motorgehäuse und dem Getriebegehäuse der Antriebseinheit in axialer Richtung festgelegt ist. Eine einzelne Bauelemente einer zum Motor gehörenden Schaltelektronik aufnehmende Leiterplatte ist in einem Elektronikgehäuse untergebracht, das als Einzelbauteil parallel zum Motorgehäuse verläuft und über eine Rippe am Motorgehäuse abgestützt sein kann; die Leiterplatte ist starr mit dem Stecker im Steckergehäuse verbunden.

Durch die DE-A1-38 05 060 ist ein Kollektormotor mit einem an der Außenseite eines Lagerschildes senkrecht zur Motorachsrichtung gehaltenen Systemträger bekannt, der neben Schaltverbindungen und Bauelementen auch durch Öffnungen im Lagerschild hindurchgreifende Bürstenhalter aufnimmt.

Eine gegenüber den vorbeschriebenen bekannten Antriebseinheiten mit geringerem Teileaufwand herstellbare und insbesondere in einfacherer Weise, vorzugsweise durch Handhabungsautomaten, montierbare Kommutator-Getriebe-Antriebseinheit der eingangs genannten Art ist erfindungsgemäß durch die Lehre des Anspruchs 1 erziehlbar; vorteilhafte Ausgestaltungen der Antriebseinheit sind jeweils Gegenstand der Unteransprüche 2-7; ein vorteilhaftes Verfahren zur Herstellung der erfindungsgemäßen Antriebseinheit ist Gegenstand des Anspruchs 8.

Die erfindungsgemäße Kommutator-Getriebe-Antriebseinheit erlaubt zumindest eine Vorfixierung und eine elektrische Kontaktierung sämtlicher elektrisch untereinander zu verbindender Komponenten an dem einen Bauteil der Leiterplatte, die auf einfache Weise als Träger und elektrisches Kontaktierungsmittel in der Antriebseinheit montierbar und fixierbar ist. Die Montierbarkeit und Justierbarkeit der die Bürstenhalterung aufnehmenden Leiterplatte kann dadurch weiter vereinfacht werden, daß der Kommutator des Kommutatormotors und der Bürstenaufnahmeteil der Leiterplatte betriebsmäßig im Bereich des Getriebegehäuses liegen, derart daß das, vorzugsweise als zylindrisches Topfgehäuse ausgebildete und in seiner offenen Stirnseite an das Getriebegehäuse angeflanschte, Motorgehäuse entsprechend axial kürzer und somit kostensparender ausgebildet werden kann.

Zur einerseits einfachen Montage der Leiterplatte mit den darauf vormontierten Komponenten und zur andererseits gewährleisteten feuchtigkeitsdichten Abschlußmöglichkeit des Getriebegehäuses und des Elektronikgehäuses ist nach einer Ausgestaltung der Erfindung vorgesehen, das Getriebegehäuse und das Elektronikgehäuse als einstückiges, topfförmiges Gehäuse auszubilden und durch einen einstückigen Getriebe- bzw. Elektronikgehäusedeckel dichtend nach der Montage der Leiterplatte zu verschließen, wobei das Steckergehäuse des Anschlußsteckers mit einem äußeren Anschlußteil aus dem Elektronikgehäusedeckel herausragt und bei dichtender Anlage eines vorstehenden Randteiles zwischen dem Elektronikgehäusedeckel und dem Topfrand des Elektronikgehäuses fixierbar ist.

Die Erfindung sowie weitere vorteilhafte Ausgestaltungen der Erfindung gemäß Merkmalen der Unteransprüche werden im folgenden anhand eines schematisch dargestellten Ausführungsbeispieles in der Zeichnung näher erläutert: Darin zeigen:
- FIG 1: in einem axialen Längsschnitt einen Kfz-Fensterheberantrieb bei geöffnetem Deckel für die Getriebe-Elektronikgehäuse-Bauteileinheit,
- FIG 2: die in den Fensterheberantrieb gemäß FIG 1 eingelegte, teilweise bestückte Leiterplatte in radialer Draufsicht,
- FIG 3: die Leiterplatte aus FIG 2 in perspektivischer Explosionsdarstellung,
- FIG 4: in einem Teilausschnitt den Fensterheberantrieb gemäß FIG 1,
- FIG 5: die Anordnung gemäß FIG 4 im Schnitt V-V,
- FIG 6: die Anordnung gemäß FIG 4 im Schnitt VI-VI.

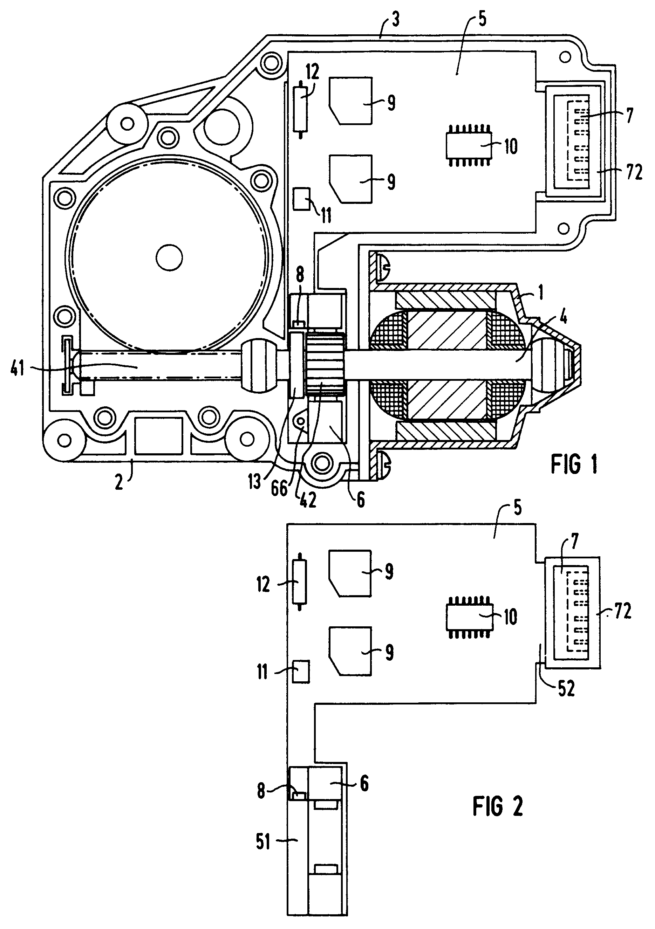

FIG 1 zeigt einen Kfz-Fensterheberantrieb mit einem einstückig spritzgegossenen, aus einem Getriebegehäuse 2 und einem Elektronikgehäuse 3 bestehenden einstückige Basisgehäuse, an das ein antreibender Kommutatormotor mit einem topfförmigen Motorgehäuse 1 mit seiner offenen Stirnseite angeschraubt ist. Die in das Getriebegehäuse 2 verlängerte Motorwelle 4 des Kommutatormotors treibt mit einer Schneckenwelle 41 in hier nicht näher erläuterter Weise ein Schneckenrad an, das z.B. mit einer Seilscheibe eines Seilzug-Fensterhebers gekuppelt ist.

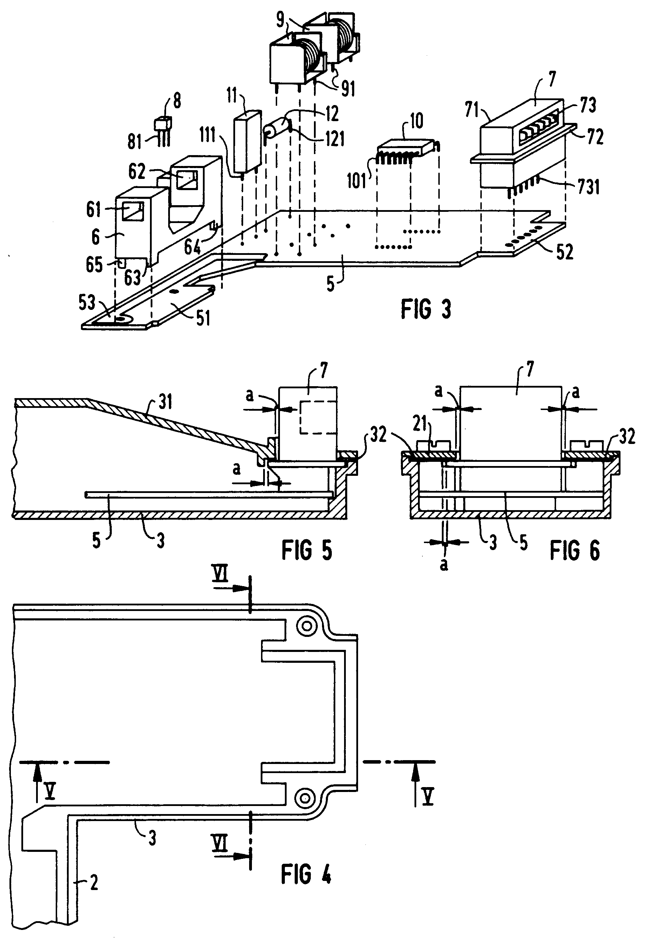

In das aus Getriebegehäuse 2 und Elektronikgehäuse 3 bestehende, topfförmig ausgebildete einstückige Basisgehäuse ist von der in FIG 1 nach oben offenen, noch nicht durch einen Deckel verschlossenen Montageseite eine in FIG 2 in Draufsicht bzw. in FIG 3 in perspektivischer Darstellung gezeigte Leiterplatte 5 eingelegt, die in ihrem in das Getriebegehäuse 2 reichenden Abschnitt einen Bürsten-Aufnahmeteil 51 und an ihrem rechten Abschnitt im Elektronikgehäuse 3 einen Anschlußstecker-Aufnahmeteil 52. Das Motorgehäuse 1 des Kommutatormotors ist axial derart verkürzt, daß der auf der Motorwelle 4 befestigte Kommutator 42 im Bereich des Getriebegehäuses 2 liegt.

Wie insbesondere aus FIG 3 ersichtlich, dient die Leiterplatte 5 nicht nur als Aufnahme- und Kontaktierungsmittel für eine Bürstenhalterung 6 im Bereich des Bürsten-Aufnahmeteiles 51 und eines Anschlußsteckers 7 im Bereich des Anschlußstecker-Aufnahmeteiles 52, sondern auch zur Aufnahme und zum elektrischen Anschluß der Bauelemente einer Motorelektronik, wie z.B. eines einem Magnetrad 13 auf der Motorwelle 4 zugeordneten Hallwandlers 8 mit seiner vorteilhaften direkten Befestigung am Bürsten-Aufnahmeteil 51 , zweier Motorrelais 9, 9, eines IC-Bausteines 10, eines Thermowächters 11 und einer Drosselspule 12. Weitere von der Leiterplatte 5 aufgenommene Bauteile sind der Deutlichkeit wegen in der Darstellung weggelassen.

Zur elektrischen Kontaktierung der von der Leiterplatte 5 aufgenommenen Bauteile sind jeweils Lotanschlüsse 65 an der Bürstenhalterung 6, Lötanschlüsse 731 an den Steckern 73 des Anschlußsteckers 7, Lötanschlüsse 81 an Hallwandler 8, Lötanschlüsse 91 an den Motorrelais 9, 9, Lötanschlüsse 101 am IC-Steuerbaustein 10, Lötanschlüsse 111 am Thermowächter 11 und Lötstellen 121 an der Drosselspule 12 vorgesehen, die durch entsprechende Kontaktierungsöffnungen der Leiterplatte 5 durchgesteckt und auf deren Rückseite durch eine gemeinsame Schwallbadlötung untereinander bzw. mit Leiterbahnen 53 der Leiterplatte 5 elektrisch kontaktiert sind. Anstelle der beschriebenen Schwallbadlötung kann bei noch moderneren Fertigungsanlagen auch eine sogenannte SMT Technik mit oberflächenmontierbaren bzw. kontaktierbaren Bauelementen vorgesehen werden.

Zur Vorfixierung der Bürstenhalterung 6 an dem Bürsten-Aufnahmeteil 51 ist die Bürstenhalterung mit Steckfüßen 63, 64 versehen, die hinter korrespondierende Ausnahmen des Bürsten-Aufnahmeteiles 51 einsetzbar sind. Die endgültige Fixierung der Bürstenhalterung 6 erfolgt z.B. mittels Schrauben in Schraubenhalterungen 66 nach der entsprechenden Justierung der Leiterplatte 5 mit Hilfe der in Bürstenführungsöffnungen 61, 62 der Bürstenhalterung 6 eingesetzen Bürsten relativ zum Kommutator 42 des zuvor am Getriebegehäuse 2 montierten Kommutatormotors im Basisgehäuse.

Die endgültige Fixierung des Anschlußsteckers 7 erfolgt durch einen Randteil 72 am Steckergehäuse 71, der - wie insbesondere aus FIG 4 bis 6 ersichtlich - in Höhe des oberen Abschlußrandes des topfförmigen Elektronikgehäuses 3 liegt und zwischen dem topfförmigen Elektronikgehäuse 3 und des nach der Montage und Justierung der Leiterplatte 5 auflegbaren Elektronikgehäusedeckels 31 unter Zwischenlage einer Dichtung 32, z.B. durch Anschrauben, fixierbar ist. In vorteilhafter Weise ist - wie insbesondere aus FIG 6 ersichtlich - der Anschlußstecker 7 im Sinne einer toleranzausgleichenden Montage frei schwimmend im Abstand "a" zu den umgebenden Randseiten des Elektronikgehäuses 3 bzw. des Elektronikgehäusedeckels 31 gehalten.

Ein vorteilhaftes Verfahren zur Herstellung einer erfindungsgemäßen Kommutator-Getriebe-Antriebseinheit ist durch folgende Verfahrensschritte gekennzeichnet:
Bestückung der Leiterplatte (5) mit der Bürstenhalterung (6), dem Anschlußstecker (7) und den Bauelementen (8-13); Kontaktieren der elektrischen Anschlüsse der Bürstenhalterung (6), des inneren Endes des Anschlußsteckers (7) sowie der Bauelemente, insbesondere durch Kontaktieren sämtlicher Anschlüsse in ein Schwallötbad, mit den Leiterbahnen (z.B. 53) der Leiterplatte (5);
Einlegen der darauf bestückten und kontaktierten Leiterplatte (5) in das Elektronik-Getriebegehäuse (2;3), Ausrichten durch Justieren der Bürstenhalterung (6) relativ zum Kommutator (42) und Fixierung der Leiterplatte (5) in ihrer justierten Endlage; Befestigen des mit Rotor und Kommutator (42) versehenen Motorgehäuses (1) am Getriebegehäuse (2); Bestückung des Getriebegehäuses (2) mit weiteren Getriebe- bzw. Lagerteilen;
Verschließen von Elektronik-Getriebegehäuse (2;3) durch den, insbesondere einstückigen, Elektronik-Getriebegehäusedeckel (21;31) mit gleichzeitiger dichtenden Festlegung des Anschlußsteckers (7).

## Patentansprüche

1. Fensterheberantrieb für ein Kraftfahrzeug mit einer Kommutator-Getriebe-Antriebseinheit, mit den Merkmalen: An das kommutator- bzw. bürstenhalterungsseitige Ende des Motorgehäuses (1) schließt sich das Getriebegehäuse (2) an, in das die verlängerte Motorwelle (4) als Getriebeantriebswelle (Schneckenwelle 41) hineinragt;
in einem Elektronikgehäuse (3) ist eine mit einem äußeren Anschlußstecker (7) und einer Bürstenhalterung (6) sowie mit Bauelementen (8-12) einer Motorelektronik elektrisch verbundene eindimensionale Leiterplatte (5) angeordnet, die eindimensionale Leiterplatte (5) weist einen einstückigen Bürsten-Aufnahmeteil (51) für die Bürstenhalterung (6) auf,
die eindimensionale Leiterplatte (5) weist einen einstückigen Anschlußstecker-Aufnahmeteil (52) für den Anschlußstekker (7) auf,
die elektrischen Anschlüsse der Bauelemente, der Bürsten und der Anschlußsteckerinnenseite sind durch ihre von der Montage-Oberseite der Leiterplatte (5) zu deren Unterseite durchgesteckten Anschlußenden, insbesondere durch Schwallbadlötung, mit den Leiterbahnen (53) der Leiterplatte (5) kontaktiert.

2. Fensterheberantrieb nach Anspruch 1, mit dem Merkmal: Der Kommutator (42) des Kommutatormotors ist im Bereich des Getriebegehäuses (2) auf der Motorwelle (4) angeordnet.

3. Fensterheberantrieb nach Anspruch 1, mit dem Merkmal: Der Bürsten-Aufnahmeteil (51) der Leiterplatte (5) ist betriebsmäßig im Bereich des Getriebegehäuses (2) angeordnet.

4. Fensterheberantrieb mit einem topfförmigen, durch einen montageseitigen Getriebegehäusedeckel (21) verschließbaren Getriebegehäuse (2) nach einem der Ansprüche 1-3, mit dem Merkmal: Das Elektronikgehäuse (3) ist einstückiger Bestandteil des Getriebegehäuses (2) und durch einen, vorzugsweise mit dem Getriebegehäusedeckel (21) einstückigen, Elektronikgehäusedeckel (31) verschließbar.

5. Fensterheberantrieb nach Anspruch 4, mit dem Merkmal: Die Leiterplatte (5) ist mit den montierten und kontaktierten Teilen der Bauelemente der Bürstenhalterung (6) sowie des Anschlußsteckers (7) von der offenen Deckelseite des Getriebegehäuses (2) bzw. Elektronikgehäuses (3) einlegbar und durch den Getriebegehäusedeckel (21) bzw. den Elektronikgehäusedeckel (31) dicht verschließbar.

6. Fensterheberantrieb nach Anspruch 4, mit dem Merkmal: Das Steckergehäuse (71) des Anschlußsteckers (7) ragt mit einem äußeren Anschlußteil aus dem Elektronikgehäusedeckel (31) heraus und ist durch dichtende Anlage eines vorstehenden Randteiles (72) zwischen dem Elektronikgehäusedeckel (31) und dem Topfrand des Elektronikgehäuses (3) fixierbar.

7. Fensterheberantrieb nach Anspruch 6, mit dem Merkmal: Der Anschlußstecker (7) ist im Sinne einer toleranzausgleichenden Montage freischwimmend in Abstand zu den umgebenden Randseiten des Elektronikgehäuses (3) bzw. des Elektronikgehäusedeckels (31) gehalten.

8. Verfahren zur Herstellung eines Fensterheberantriebs nach Anspruch 1-7, mit den Verfahrensschritten:
Bestückung der Leiterplatte (5) mit der Bürstenhalterung (6), dem Anschlußstecker (7) und den Bauelementen (8-13); Kontaktieren der elektrischen Anschlüsse der Bürstenhalterung (6), des inneren Endes des Anschlußsteckers (7) sowie der Bauelemente, insbesondere durch Kontaktieren sämtlicher Anschlüsse in einem Schwallötbad, mit den Leiterbahnen (z.B. 53) der Leiterplatte (5);
Einlegen der darauf bestückten und kontaktierten Leiterplatte (5) in das Elektronik-Getriebegehäuse (2;3), Ausrichten durch Justieren der Bürstenhalterung (6) relativ zum Kommutator (42) und Fixierung der Leiterplatte (5) in ihrer justierten Endlage;
Befestigen des mit Rotor und Kommutator (42) versehenen Motorgehäuses (1) am Getriebegehäuse (2);
Bestückung des Getriebegehäuses (2) mit weiteren Getriebe- bzw. Lagerteilen;
Verschließen von Elektronik-Getriebegehäuse (2;3) durch den, insbesondere einstückigen, Elektronik-Getriebegehäusedeckel (21;31) mit gleichzeitiger dichtenden Festlegung des Anschlußsteckers (7).

## Claims

1. Window raising drive for a motor vehicle having a commutator gear drive unit, having the following features:
the gear casing (2) is connected to the end of the motor casing (1) on the commutator and/or brush mounting side, with the extended motor shaft (4) projecting as a gear drive shaft (worm shaft 41) into the gear casing (2);
a unidimensional printed-circuit board (5) electrically connected to an external attachment plug (7) and a brush mounting (6) and to components (8 to 12) of an engine electronics system, is arranged in an electronics casing (3);
the unidimensional printed-circuit board (5) has an integral brush holding part (51) for the brush mounting (6),
the unidimensional printed-circuit board (5) has an integral attachment plug holding part (52) for the attachment plug (7),
the electrical connections of the components, of the brushes and of the interior of the attachment plug are bonded, in particular by dip soldering, to the printed conductors (53) of the printed-circuit board (5) by their terminals which are inserted from the upper assembly side of the printed-circuit board (5) to the lower side thereof.

2. Window raising drive according to claim 1, having the following feature:
the commutator (42) of the commutator motor is arranged on the motor shaft (4) in the region of the gear casing (2).

3. Window raising drive according to claim 1, having the following feature:
the brush holding part (51) of the printed-circuit board (5) is arranged for operation in the region of the gear casing (2).

4. Window raising drive having a pot-shaped gear casing (2) according to one of claims 1 to 3, which gear casing (2) can be closed by means of a gear casing cover (21) on the assembly side, having the following feature:
the electronics casing (3) is an integral component part of the gear casing (2) and can be closed by means of an electronics casing cover (31) which is preferably formed in one piece with the gear casing cover (21).

5. Window rasing drive according to claim 4, having the following feature:
the printed-circuit board (5) can be inserted from the open cover side of the gear casing (2) and/or electronics casing (3), together with the assembled and bonded parts of the components of the brush mounting (6) and of the attachment plug (7), and can be sealed by means of the gear casing cover (21) and/or the electronics casing cover (31).

6. Window raising drive according to claim 4, having the following feature:
the plug casing (71) of the attachment plug (7) projects from the electronics casing cover (31) by means of an external connection part and can be fixed in position between the electronics casing cover (31) and the pot edge of the electronics casing (3) by means of the sealed seating of a protruding edge part (72).

7. Window raising drive according to claim 6, having the following feature:
the attachment plug (7) is held in a free-floating manner at a distance from the surrounding edges of the electronics casing (3) or the electronics casing cover (31), in the sense of a tolerance balancing assembly.

8. Method for the manufacture of a window raising drive according to claims 1 to 7, having the following method steps:
completing the printed-circuit board (5) with the brush mounting (6), the attachment plug (7) and the components (8 to 13);
bonding the electrical connections of the brush mounting (6), of the inner end of the attachment plug (7) and of the components to the printed conductors (for example 53 of the printed-circuit board 5), in particular by bonding all of the connections in one dip soldering bath;
inserting the printed-circuit board (5), fitted and bonded in this way, in the electronics gear casing (2;3), aligning the brush mounting (6) by adjustment relative to the commutator (42) and securing the printed-circuit board (5) in its final adjusted position;
securing the motor casing (1) provided with the rotor and commutator (42), to the gear casing (2); fitting the gear casing (2) with further gear parts and/or bearing parts;
closing the electronics/gear casing (2;3) by means of the electronics/gear casing cover (21;31) which is in particular an integral electronics/gear casing cover, with simultaneous sealed fastening of the attachment plug (7).

## Revendications

1. Dispositif d'entraînement de glace pour véhicule automobile, comportant un ensemble moteur à collecteur-réducteur, ayant les caractéristiques suivantes :
- à l'extrémité du corps (1) du moteur située du côté du collecteur ou du support de balais, se raccorde un carter (2) de boîte d'engrenages dans lequel pénètre l'arbre (4) prolongé du moteur, en tant qu'arbre d'entraînement de boîte d'engrenages (arbre à vis sans fin (41)) ;
- dans un boîtier électronique (3) est disposée une plaquette (5) de circuit imprimé monodimensionnelle connectée électriquement à une fiche de branchement (7) extérieure et à un support (6) de balais, ainsi qu'à des composants (8 à 12) d'un dispositif électronique du moteur ;
- la plaquette (5) de circuit imprimé monodimensionnelle comporte une pièce de réception (51), faisant corps avec elle et destinée au support (6) de balais ;
- la plaquette de circuit imprimé (5) monodimensionnelle comporte une pièce de réception (52) faisant corps avec elle et destinée à la fiche de branchement (7) ;
- les bornes électriques des composants, des balais et du côté intérieur de la fiche de branchement sont mis en contact avec les pistes conductrices (53) de la plaquette (5) de circuit imprimé par leurs extrémités de branchement enfilées à partir du côté supérieur de la plaquette (5) de circuit imprimé, jusqu'à ce qu'elles atteignent le côté inférieur de celle-ci, notamment par brasage tendre à la vague.

2. Dispositif d'entraînement de glace selon la revendication 1, caractérisé en ce que
le collecteur (42) du moteur à collecteur est monté sur l'arbre (4) du moteur dans la zone du carter (2) de boîte d'engrenages.

3. Dispositif d'entraînement de glace selon la revendication 1, caractérisé en ce que
la pièce de réception (51) de balai de la plaquette (5) de circuit imprimé est montée fonctionnellement dans la zone du carter (2) de boîte d'engrenages.

4. Dispositif d'entraînement de glace comportant un carter (2) de boîte d'engrenages susceptible d'être fermé du côté de montage par un couvercle (2) de carter de boîte d'engrenages, selon l'une des revendications 1 à 3, caractérisé en ce que
le corps (3) du dispositif électronique est une pièce constitutive du carter (2) de boîte d'engrenages, faisant corps avec celui-ci, et il peut être fermé par le couvercle (31) de boitier électronique, faisant de préférence corps avec le couvercle (21) de carter de boîte d'engrenages.

5. Dispositif d'entraînement de glace selon la revendication 4, caractérisé en ce que
la plaquette (5) de circuit imprimé peut être mise en place, avec les parties montées et connectées des composants du support (6) de balais ainsi que celles de la fiche de branchement (7), à partir du côté couvercle ouvert du carter (2) de boîte d'engrenages, ou du boîtier (3) électronique et elle peut être enfermée de façon étanche au moyen du couvercle (21) de boîte d'engrenages ou du couvercle (3) de boîtier électronique.

6. Dispositif d'entraînement de glace selon la revendication 4, caractérisé en ce que
le corps (71) de la fiche (7) de branchement dépasse par une pièce de branchement extérieure du couvercle (31) du boîtier électronique et il peut être fixé par application étanche d'une partie (72) de bord faisant saillie, entre le couvercle (31) de boîtier électronique et le bord de cuve du boîtier électronique (3).

7. Dispositif d'entraînement de glace selon la revendication 6, caractérisé en ce que
la fiche de branchement (7) est maintenue avec débattement libre, en vue d'un montage permettant la compensation des tolérances, à distance des côtés formant le bord périphérique du boîtier électronique (3) ou du couvercle (31) du boîtier électronique.

8. Procédé de fabrication d'un dispositif d'entraînement de glace selon les revendications 1 à 7, comportant les opérations suivantes :
- mise en place sur la plaquette (5) de circuit imprimé du support (6) de balais, de la fiche de branchement (7) et des composants (8 à 13) ;
- mise en contact avec les pistes conductrices (par exemple 53) de la plaquette (5) de circuit imprimé, des bornes électriques du support (6) de balais, de l'extrémité intérieure de la fiche de branchement (7) ainsi que des composants, notamment par la mise en contact de l'ensemble des bornes dans un bain de brasure tendre à la vague ;
- mise en place dans le carter (2 ; 3) de boîte d'engrenages et de dispositif électronique, de la plaquette (5) de circuit imprimé équipés et munis des contacts, alignement de la plaquette (5) de circuit imprimé par réglage du support (6) de balais par rapport au collecteur (42) et fixation de celle-ci dans sa position finale ajustée ;
- fixation sur le carter (2) de boîte d'engrenages du corps (1) de moteur muni du rotor et du collecteur (42) ;
- mise en place sur le carter (2) de boîte d'engrenages, d'autres pièces d'engrenages ou de paliers ;
- fermeture du carter (2 ; 3) de boîte d'engrenages et de dispositif électronique par le couvercle (21 ; 31) de carter de boîte d'engrenages et de dispositif électronique, formant notamment une seule pièce, avec fixation étanche simultanée de la fiche de branchement (7).
